# EUROPÄISCHE PATENTSCHRIFT

(11) **EP 2 002 176 B1**
(45) Veröffentlichungstag und Bekanntmachung des Hinweises auf die Patenterteilung: **29.04.2020**
(21) Anmeldenummer: 07722079.6
(22) Anmeldetag: 20.03.2007
(51) Int. Cl.: F21S 41/143, H01L 27/15, H01L 33/44, H01L 33/62, F21S 41/663, F21Y 115/10, H01L 25/075, H01L 25/16, H01L 33/20, H01L 33/50

(54) **OPTOELEKTRONISCHER FRONTSCHEINWERFER**
OPTOELECTRONIC HEADLIGHT
PHARE AVANT OPTOÉLECTRONIQUE

(30) Priorität: 31.03.2006 DE 102006015117
(43) Veröffentlichungstag der Anmeldung: 17.12.2008
(73) Patentinhaber: OSRAM Opto Semiconductors GmbH, 93055 Regensburg (DE)
(72) Erfinder: BAUR, Johannes, 93051 Regensburg (DE); REILL, Joachim, 93197 Zeitlarn (DE); SORG, Jörg Erich, 93053 Regensburg (DE)
(74) Vertreter: Epping - Hermann - Fischer
(86) Internationale Anmeldenummer: PCT/DE2007/000519
(87) Internationale Veröffentlichungsnummer: WO 2007/115523

(56) Entgegenhaltungen:
- EP-A- 1 515 368
- EP-A- 1 526 581
- EP-A1- 1 553 640
- WO-A1-2005/120135
- US-A1- 2002 015 013
- US-A1- 2004 041 159
- US-B1- 6 375 340

## Beschreibung

Die Erfindung betrifft einen optoelektronischen Frontscheinwerfer mit mindestens einem Lumineszenzdiodenchip, der eine elektromagnetische Strahlung emittiert. Die Erfindung ist durch den Patentanspruch 1 definiert.

Diese Patentanmeldung beansprucht die Priorität der deutschen Patentanmeldung 102006015117.8.

Ein optoelektronischer Scheinwerfer ist beispielsweise in der WO 2004/088200 A2 beschrieben. Dieser weist eine Mehrzahl von Scheinwerferelementen auf, die jeweils mindestens einen Lumineszenzdiodenchip, ein dem Lumineszenzdiodenchip zugeordnetes Primäroptikelement sowie einen Scheinwerferelementausgang aufweisen. Die Scheinwerferelementausgänge sind in mindestens zwei Gruppen derart angeordnet, dass ihre Anordnung einer gewünschten Abstrahlcharakteristik des Scheinwerfers entspricht. Die beiden Gruppen von Scheinwerferelementen lassen sich unabhängig voneinander in Betrieb nehmen. Ein optoelektronischer Scheinwerfer ist auch in der EP 1 515 368 A2 beschrieben. Ein weiterer optoelektronischer Scheinwerfer ist in der EP 1 526 581 A2 beschrieben.

Es ist eine Aufgabe der vorliegenden Erfindung, einen alternativen optoelektronischen Scheinwerfer der eingangs genannten Art anzugeben, mittels dem eine möglichst gute Realisierung vorgegebener Abstrahlcharakteristik realisiert werden kann.

Diese Aufgabe wird durch den optoelektronischen Frontscheinwerfer gemäß dem unabhängigen Patentanspruch 1 gelöst. Vorteilhafte Weiterbildungen und bevorzugte Ausgestaltungen des Frontscheinwerfers sind Gegenstand der jeweiligen abhängigen Ansprüche. Im Folgenden werden Teile der Beschreibung und Zeichnungen, die sich auf Ausführungsformen oder Ausführungsbeispiele beziehen, die nicht von den Ansprüchen abgedeckt sind, nicht als Ausführungsformen oder Ausführungsbeispiele der Erfindung präsentiert, sondern als Beispiele, die zum Verständnis der Erfindung nützlich sind.

Es wird ein Frontscheinwerfer der eingangs genannten Art angegeben, der einen Lumineszenzdiodenchip mit mindestens zwei räumlichen Emissionsbereichen aufweist. Zumindest Teilbereiche der Emissionsbereiche sind lateral voneinander beabstandet, d.h. die Emissionsbereiche überlappen lateral nicht. Die Emissionsbereiche sind in einer Draufsicht auf eine ihnen zugeordnete Haupterstreckungsebene unterschiedlich geformt, unterschiedlich groß und/oder nicht rechteckig geformt und unterschiedlich orientiert. Die Emissionsbereiche sind unabhängig voneinander ansteuerbar. Der Lumineszenzdiodenchip ist auf einem Trägerkörper angeordnet und zusammen mit dem Trägerkörper mit einer elektrischen Isolierschicht bedeckt ist, auf der eine elektrische Leiterbahnstruktur ausgebildet ist, wobei die Emissionsbereiche jeweils mindestens eine elektrische Anschlussfläche aufweisen, die mit der Leiterbahnstruktur verbunden ist. Der Frontscheinwerfer weist ein optisches Element zur Ausbildung eines Strahlenkegels auf.

Die Haupterstreckungsebenen der Emissionsbereiche verlaufend mit Vorteil im Wesentlichen parallel zueinander. Mit einer Mehrzahl unterschiedlicher Emissionsbereiche, die unterschiedlich geformt, unterschiedlich groß und/oder nicht rechteckig und unterschiedlich orientiert sind, lassen sich unterschiedliche gewünschte Abstrahlcharakteristiken des Scheinwerfers für unterschiedlichste Anwendungsgebiete auf präzise Weise realisieren. Erfindungsgemäß ist der Scheinwerfer ein Frontscheinwerfer für Kraftfahrzeuge. Zudem ist eine Beleuchtungseinheit für Projektionsanwendungen, beispielsweise für einen Videoprojektor, offenbart.

Mit dem Scheinwerfer lassen sich unterschiedliche Scheinwerferfunktionen vorteilhaft umsetzen. Bei einem Frontscheinwerfer für Kraftfahrzeuge sind dies beispielsweise Autobahnlicht, Stadtlicht, Landstraßenlicht und Kurvenlicht, die durch eine entsprechende Verschaltung und Ansteuerung der der Emissionsbereiche realisierbar sind.

Die Form, Größe und/oder Orientierung der Emissionsbereiche ist mit Vorteil derart gewählt, dass ein Emissionsbereich oder mehrere Emissionsbereiche gemeinsam eine Form ergeben, die im Wesentlichen einer Querschnittsform eines gewünschten Scheinwerferkegels entspricht. Mit Scheinwerferkegel ist hierbei sowie im Folgenden ein beliebig geformtes Volumen gemeint, das durch das Scheinwerferlicht durchleuchtet ist, wobei Bereiche ausgeschlossen sind, in denen die Helligkeit mehr als eine Größenordnung geringer ist als die maximale Helligkeit bei gleichem Abstand zum Scheinwerfer. Unter Abstrahlcharakteristik sind eine oder mehrere Eigenschaften des Scheinwerferkegels, wie zum Beispiel Lichtintensität in verschiedenen Raumwinkeln, Hell-/ Dunkel-Übergänge oder eine Querschnittsform zu verstehen. Mit Querschnittsform ist die Form eines Querschnitts des Scheinwerferkegels in einer Ebene senkrecht zu einer Hauptabstrahlrichtung des Scheinwerfers gemeint.

Die Form mindestens eines der Emissionsbereiche in einer Draufsicht auf die Haupterstreckungsebene ist gemäß einer vorteilhaften Ausführungsform nicht rechteckig. Der Emissionsbereich weist insbesondere entlang von Linien verlaufende Grenzen auf, die schräg zueinander ausgerichtet sind.

Gemäß einer besonders bevorzugten Ausführungsform weist die Form mindestens eines der Emissionsbereiche in einer Draufsicht auf die Haupterstreckungsebene eine Ecke mit einem spitzen Winkel oder mit einem stumpfen Winkel auf. Zusätzlich oder alternativ weist die Form mindestens eines der Emissionsbereiche in einer Draufsicht auf die Haupterstreckungsebene einen Knick mit einem überstumpfen Winkel auf. Unter einem "Knick" ist nicht notwendigerweise eine scharfe Ecke zu verstehen. Vielmehr kann der Knick auch beispielsweise abgerundet sein.

Bevorzugt weist die Form mindestens eines der Emissionsbereiche in einer Draufsicht auf die Haupterstreckungsebene keine Symmetrieachse auf. Mit derartigen Emissionsbereichen lassen sich insbesondere Scheinwerferkegel mit einem unsymmetrischen Querschnitt und/oder einer unsymmetrischen Lichtdichteverteilung realisieren.

Zweckmäßigerweise weisen benachbarte Emissionsbereiche in lateraler Richtung zueinander einen relativ kleinen Abstand auf. Der Abstand beträgt mit Vorteil weniger als oder gleich 100 µm, bevorzugt weniger als oder gleich 50 µm, besonders bevorzugt weniger als oder gleich 20 µm. Mit einem derart geringen Abstand lassen sich Scheinwerferkegel einer besonders homogenen Lichtdichteverteilung realisieren.

Gemäß der vorliegenden Erfindung ist der Lumineszenzdiodenchip auf einem Trägerkörper angeordnet und zusammen mit dem Trägerkörper mit einer elektrischen Isolierschicht bedeckt. Auf der Isolierschicht ist eine elektrische Leiterbahnstruktur ausgebildet, wobei die Emissionsbereiche jeweils mindestens eine elektrische Anschlussfläche aufweisen, die mit der Leiterbahnstruktur verbunden ist. Die elektrischen Anschlussflächen sind insbesondere elektrisch leitend mit der Leiterbahnstruktur verbunden. Bevorzugt sind die Anschlussflächen zudem auch mechanisch mit der Leiterbahnstruktur verbunden.

Die Leiterbahnstruktur kann grundsätzlich beliebig aufgebaut und strukturiert sein, sie kann im Einzelfall insbesondere auch aus einer unstrukturierten elektrisch leitfähigen Schicht bestehen. Bevorzugt umfasst die Leiterbahnstruktur mehrere Leiterbahnen, die sowohl miteinander verbunden als auch zusätzlich oder alternativ elektrisch voneinander isoliert sein können.

Eine derart ausgebildete Leiterbahnstruktur zum elektrisch leitenden Kontaktieren und Verschalten des Lumineszenzdiodenchips oder der Lumineszenzdiodenchips ist für Scheinwerferapplikationen besonders vorteilhaft. Dadurch ermöglicht der Scheinwerfer nicht nur eine präzise Realisierung verschiedener Abstrahlcharakteristiken, sondern er lässt sich zudem auch kostengünstig elektrisch leitend montieren und verschalten sowie mit einem optischen Element versehen, das sehr nah an die Emissionsbereiche gebracht werden kann. Optische Elemente lassen sich insbesondere näher an die Emissionsbereiche heranbringen, als dies bei einer elektrischen Kontaktierung des Lumineszenzdiodenchips oder der Lumineszenzdiodenchips mittels eines oder mehrerer Bonddrähte möglich wäre.

Erfindungsgemäß weist der Frontscheinwerfer mindestens ein optisches Element auf. Bevorzugt ist jedem Lumineszenzdiodenchip mindestens ein optisches Element zugeordnet, besonders bevorzugt sind mehrere oder alle Emissionsbereiche gemeinsam einem optischen Element zugeordnet. Das optische Element dient zur Ausbildung eines Strahlenkegels mit einer möglichst hohen Strahlenintensität und einer möglichst geringen Divergenz.

Bevorzugt ist mehreren Lumineszenzdiodenchips gemeinsam ein optisches Element zugeordnet. Dies hat beispielsweise den Vorteil einer vereinfachten Montage, verglichen mit dem Fall, dass jedem Lumineszenzdiodenchip ein eigenes optisches Element zugeordnet ist.

Es ist besonders vorteilhaft, wenn ein Lichteingang des optischen Elements möglichst nahe an einem Lumineszenzdiodenchip positioniert ist, was mit der angegebenen drahtlosen Kontaktierung mit Vorteil besonders gut möglich ist, da diese, verglichen mit einer Kontaktierung mittels eines Bonddrahtes, mit einer besonders geringen Höhe ausgebildet werden kann. Zweckmäßigerweise wird der Raumwinkel, in dem das Licht aus dem optischen Element emittiert wird, mittels des optischen Elementes möglichst nah an den Lumineszenzdiodenchip verkleinert, wo eine Querschnittsfläche des Strahlenkegels noch klein ist. Dies ist insbesondere dann erforderlich, wenn eine möglichst hohe Strahlungsstärke auf eine möglichst kleine Fläche projiziert werden soll, wie das bei Scheinwerferapplikationen oder Projektionseinrichtungen der Fall ist.

Gemäß einer besonders vorteilhaften Ausführungsform ist auf dem Trägerkörper zusätzlich zu dem Lumineszenzdiodenchip ein elektronisches Bauelement angeordnet, das mindestens eine elektrische Anschlussfläche aufweist, die über die Leiterbahnstruktur elektrisch leitend angeschlossen ist. Bevorzugt ist die Anschlussfläche des Bauelements über die Leiterbahnstruktur elektrisch leitend mit mindestens einer Anschlussfläche der Emissionsbereiche verbunden. Das elektrische Bauelement ist zu dem Lumineszenzdiodenchip verschiedenartig. Verschiedenartig heißt, dass sich die Bauelemente in funktionellen und/oder strukturellen Merkmalen unterscheiden, wobei sie insbesondere unterschiedliche Zwecke erfüllen, in ihrer Wirkungsweise auf unterschiedlichen physikalischen Effekten beruhen, unterschiedlich geformte elektrische Anschlussflächen aufweisen oder auf unterschiedliche Weise montierbar sein können.

In einer besonders zweckmäßigen Ausführungsform ist das elektronische Bauelement ein passives Bauelement und/oder ein integrierter Schaltkreis. Es ist bevorzugt für eine SMD-Montage geeignet (surface mountable device Montage). Zusätzlich oder alternativ ist das Bauelement für eine Montage geeignet, die eine Verwendung von Bonddrähten beinhaltet. Derartige Bauelemente können in dem Scheinwerfer mit Vorteil statt mittels Lot oder mittels Bonddrähten zumindest teilweise anhand der Leiterbahnstruktur elektrisch leitend angeschlossen sein.

Bei dem optoelektronischen Scheinwerfer ist es grundsätzlich möglich, Leiterbahnen, die bei herkömmlichen derartigen Scheinwerfern ein Bestandteil des Trägerkörpers, sind, teilweise oder vollständige durch die auf die Isolierschicht aufgebrachten Leiterbahnstruktur zu ersetzen. Dies ermöglicht zum einen eine technisch einfach zu realisierende elektrische Montage von Bauelementen und Lumineszenzdiodenchips und zum anderen die Verwendung von kostengünstigen Trägerkörpern.

Mit Vorteil ist die elektrische Anschlussfläche mindestens eines Emissionsbereichs mit einem Anschlussbereich des Trägerkörpers über die Leiterbahnstruktur elektrisch leitend verbunden.

Die Isolierschicht weist mit besonderem Vorteil ein • Lumineszenz-Konversionsmaterial auf. Mittels des Lumineszenz-Konversionsmaterials lässt sich eine von dem Bauelement zu emittierende elektromagnetische Strahlung aus einem ersten Wellenlängenbereich in eine elektromagnetische Strahlung aus einem zweiten Wellenlängenbereich konvertierten. Beispielsweise lässt sich auf diese Weise blaue Strahlung teilweise in gelbe Strahlung konvertieren. Bei geeignetem Intensitätsverhältnis von blauer und gelber Strahlung lässt sich so weißes Licht erzeugen. Bei einer derartigen Lumineszenzkonversion ist im Hinblick auf die Effizienz besonders vorteilhaft, wenn die Isolierschicht unmittelbar an die zur Strahlungsauskopplung vorgesehene Oberfläche der Emissionsbereiche angrenzt.

In einer zweckmäßigen Ausführungsform ist der Lumineszenzdiodenchip oder sind die Lumineszenzdiodenchips auf einem Chipträger montiert, der auf dem Trägerkörper aufgebracht ist. Durch die Verwendung eines separaten Chipträgers kann beispielsweise bei geeigneter Auswahl von Materialien eine besonders gute Wärmeabführung von dem Lumineszenzdiodenchip realisiert werden. Der Chipträger kann auch ein Gehäusekörper eines Lumineszenzdioden-Bauelements sein, wobei eine vollständige elektrische Montage des Lumineszenzdiodenchips an dem Chipgehäuse mit Vorteil nicht erforderlich ist. Vielmehr können die Lumineszenzdiodenchips erst nach dem Aufbringen des Chipträgers auf dem Trägerkörper mittels der Leiterbahnstruktur elektrisch leitend angeschlossen werden.

Es wird ein Verfahren zum Herstellen eines optoelektronischen Scheinwerfers angegeben, der eine elektromagnetische Strahlung emittiert. Bei dem Verfahren wird ein Trägerkörper und mindestens ein Lumineszenzdiodenchip bereitgestellt, wobei der Lumineszenzdiodenchip mindestens zwei Emissionsbereiche aufweist, die in einer Draufsicht auf eine ihnen zugeordnete Haupterstreckungsebene unterschiedlich geformt, unterschiedlich groß und/oder bei gleichartiger Form unterschiedlich orientiert sind. Jeder der Emissionsbereiche weist mindestens eine elektrische Anschlussfläche auf. Erfindungsgemäß sind die Emissionsbereiche unabhängig voneinander ansteuerbar.

Der Lumineszenzdiodenchip wird auf dem Trägerkörper aufgebracht. Nachfolgend wird auf den Lumineszenzdiodenchip und den Trägerkörper eine Isolierschicht aufgebracht. In einem weiteren Verfahrensschritt werden zum Freilegen von mindestens jeweils einer elektrischen Anschlussfläche der Emissionsbereiche Ausnehmungen in der Isolierschicht ausgebildet. Auf der Isolierschicht wird elektrisch leitfähiges Material derart aufgebracht, dass es mit den elektrischen Anschlussflächen verbunden wird, zum Ausbilden einer elektrischen Leiterbahnstruktur.

Zweckmäßigerweise wird das elektrisch leitfähige Material in Form einer Schicht aufgebracht. Diese Schicht kann, je nach Ausführung und Form der zu realisierenden Leiterbahnstruktur, nachfolgend zweckmäßigerweise strukturiert werden, sodass insbesondere auch elektrisch voneinander isolierte Leiterbahnen der Leiterbahnstruktur hergestellt werden können.

Es wird ein weiteres Verfahren zum Herstellen eines elektromagnetische Strahlung emittierenden optoelektronischen Scheinwerfers angegeben, bei dem neben einem Trägerkörper mindestens zwei Lumineszenzdiodenchips bereitgestellt werden. Die Lumineszenzdiodenchips weisen jeweils mindestens einen Emissionsbereich mit mindestens einer elektrischen Anschlussfläche auf. In einer Draufsicht auf eine ihnen zugeordnete Haupterstreckungsebene sind die Emissionsbereiche unterschiedlich geformt, unterschiedlich groß und/oder nicht rechteckig geformt und unterschiedlich orientiert.

Weitere Verfahrensschritte umfassen ein Aufbringen des Lumineszenzdiodenchips auf dem Trägerkörper, ein Aufbringen einer Isolierschicht auf den Lumineszenzdiodenchip und den Trägerkörper, ein Ausbilden von Ausnehmungen in der Isolierschicht zum Freilegen von mindestens jeweils einer elektrischen Anschlussfläche der Emissionsbereiche, und ein Aufbringen von elektrisch leitfähigem Material auf die Isolierschicht, derart, dass es mit den elektrischen Anschlussflächen verbunden wird, zum Ausbilden einer elektrischen Leiterbahnstruktur. Die Leiterbahnstruktur kann wie vorhergehend beschrieben ausgebildet werden.

Bei einer bevorzugten Ausführungsform der Verfahren wird mindestens ein elektrisches Bauelement bereitgestellt und vor dem Aufbringen der Isolierschicht auf dem Trägerkörper aufgebracht. Das Aufbringen der Isolierschicht erfolgt derart, dass auch das elektrische Bauelement teilweise oder vollständig bedeckt wird. Weitere Verfahrensschritte dieser Ausführungsform umfassen das Ausbilden von Ausnehmungen in der Isolierschicht zum Freilegen der elektrischen Anschlussfläche des Bauelements, und ein Aufbringen von elektrisch leitfähigem Material auf die Isolierschicht zum Ausbilden einer elektrischen Leiterbahnstruktur, derart, dass das elektrisch leitfähige Material mit der elektrischen Anschlussfläche des Bauelements verbunden wird.

Mit besonderem Vorteil werden mehrere Scheinwerfer gemeinsam und im Wesentlichen gleichzeitig hergestellt. Insbesondere das Aufbringen der Isolierschicht, das Ausbilden von Ausnehmungen und das Aufbringen von elektrisch leitfähigem Material lässt sich in einer Reihe von Batch-Prozessen durchführen. In diesen Batch-Prozessen kann eine Vielzahl von optoelektronischen Scheinwerfern parallel prozessiert werden, was eine kostengünstige Alternative zu der Verwendung von Einzelprozessen ist, wie sie zum Beispiel beim Bonden unter Verwendung von Bonddrähten nötig sind. Bei einem Einsatz von Batch-Prozessen kann zudem auch der Investitionsbedarf für notwendige Betriebsanlagen gering gehalten werden.

Die Batch-Prozesse sind flexibel auf verschiedene Produkte einzurichten. Es ist grundsätzlich möglich, verschiedene Produkte auf einer Fertigungslinie herzustellen. Das kann sowohl nacheinander, nach einer Umstellung von sich unterscheidenden Verfahrensparametern oder auch parallel erfolgen. Das Verfahren lässt sich insbesondere zum elektrisch leitenden Kontaktieren und Anschließen von Bauelementen verschiedener Bauteilklassen verwenden.

Mit Vorteil umfasst das Aufbringen der Isolierschicht ein Aufbringen einer vorgefertigten Schicht. Zusätzlich oder alternativ umfasst das Aufbringen der Isolierschicht mit Vorteil ein Aufdrucken, ein Aufsprühen oder Aufschleudern eines Materials für die Isolierschicht. Durch diese Maßnahmen lässt sich das Aufbringen der Isolierschicht auf technisch einfache und kostengünstige Weise realisieren.

Bei einer besonders bevorzugten Variante des Verfahrens wird zum Aufbringen der Isolierschicht zunächst eine Precursor-Schicht auf den Lumineszenzdiodenchip und den Trägerkörper aufgebracht. Dies erfolgt beispielsweise mittels eines Sol-Gel-Verfahrens, durch Aufdampfen oder durch Aufschleudern (Spincoating) einer Suspension. Eine erste Temperaturbehandlung wird vorgenommen, die geeignet ist, organische Bestandteile aus der Precursor-Schicht zu entfernen. Nachfolgend wird das Material einer zweiten Temperaturbehandlung unterzogen, die dazu geeignet ist, die Precursor-Schicht zu verdichten. Durch dieses Verfahren lässt sich insbesondere eine dünne und gleichmäßige Glasschicht erzeugen.

Die Ausnehmungen in der Isolierschicht werden vorzugsweise durch einen Verfahrensschritt hergestellt, der eine Laserbearbeitung umfasst. Dabei wird die Isolierschicht in den Bereichen der herzustellenden Ausnehmungen unter Verwendung von Laserstrahlung abgetragen. Bei einer Laserbearbeitung kann die Größe, Form und Tiefe der Ausnehmungen präzise eingestellt und unmittelbar erzeugt werden.

Das Aufbringen von elektrisch leitfähigem Material umfasst vorteilhaft das Aufbringen einer Metallschicht mittels eines PVD-Verfahrens und ein Verstärken der Metallschicht mittels galvanischer Abscheidung. Ein geeignetes PVD-Verfahren ist beispielsweise Sputtern.

Alternativ kann das elektrisch leitfähige Material auch unter Verwendung eines Druckverfahrens, insbesondere eines Siebdruckverfahrens, aufgebracht werden. Ferner kann das elektrisch leitfähige Material auch unter Verwendung eines Aufsprühverfahrens oder eines Aufschleuderverfahrens (Spincoating) erzeugt werden.

Es wird ein Lumineszenzdiodenchip angegeben, der eine elektromagnetische Strahlung emittiert. Der Lumineszenzdiodenchip weist mindestens zwei unabhängig voneinander ansteuerbare Emissionsbereiche auf, die in einer Draufsicht auf eine ihnen zugeordnete Haupterstreckungsebene unterschiedlich geformt, unterschiedlich groß und/oder bei gleichartiger Form unterschiedlich orientiert sind. Der Lumineszenzdiodenchip eignet sich mit besonderem Vorteil für eine Anwendung in dem optoelektronischen Scheinwerfer.

Gemäß einer besonders vorteilhaften Ausführungsform des Lumineszenzdiodenchips ist vorgesehen, dass die Form mindestens eines der Emissionsbereiche in einer Draufsicht auf die Haupterstreckungsebene nicht rechteckig ist, eine Ecke mit einem spitzen oder einem stumpfen Winkel aufweist, einen Knick mit einem überstumpfen Winkel aufweist und/oder keine Symmetrieachse aufweist.

Weitere Vorteile, bevorzugte Ausführungsformen und Zweckmäßigkeiten des Scheinwerfers, der Verfahren und des Lumineszenzdiodenchips ergeben sich aus den im Folgenden in Verbindung mit den Figuren beschriebenen Ausführungsbeispielen.

Es zeigen:
- Figur 1: eine schematische Draufsicht auf einen Lumineszenzdiodenchip gemäß eines ersten Ausführungsbeispiels,
- Figur 2: eine schematische Draufsicht auf einen Lumineszenzdiodenchip gemäß eines zweiten Ausführungsbeispiels,
- Figur 3: eine schematische Draufsicht auf einen Lumineszenzdiodenchip gemäß eines dritten Ausführungsbeispiels,
- Figur 4: eine schematische Schnittansicht des in Figur 1 dargestellten Lumineszenzdiodenchips,
- Figur 5: eine schematische Draufsicht auf einen Ausschnitt eines optoelektronischen Scheinwerfers gemäß eines ersten Ausführungsbeispiels,
- Figur 6: eine schematische Draufsicht auf einen Ausschnitt eines optoelektronischen Scheinwerfers gemäß eines zweiten Ausführungsbeispiels,
- Figur 7: eine schematische Draufsicht auf einen Ausschnitt eines optoelektronischen Scheinwerfers gemäß eines dritten Ausführungsbeispiels,
- Figuren 8 bis 13: schematische Schnittansichten verschiedener Verfahrensstadien zur Herstellung des in Figur 5 dargestellten Scheinwerfers gemäß eines ersten Ausführungsbeispiels des Verfahrens,
- Figur 14: eine schematische Schnittansicht eines Verfahrensstadiums zur Herstellung des in Figur 5 dargestellten Scheinwerfers gemäß eines zweiten Ausführungsbeispiels des Verfahrens, und
- Figuren 15 bis 21: schematische Schnittansichten verschiedener Verfahrensstadien eines dritten Ausführungsbeispiels des Verfahrens zur Herstellung des in Figur 6 dargestellten optoelektronischen Scheinwerfers.

In den Ausführungsbeispielen und Figuren sind gleiche oder gleich wirkende Bestandteile jeweils mit den gleichen Bezugszeichen versehen. Die dargestellten Elemente sowie die Größenverhältnisse der Elemente untereinander sind nicht notwendigerweise als maßstabsgerecht anzusehen. Vielmehr sind einige Details der Figuren zum besseren Verständnis übertrieben groß dargestellt.

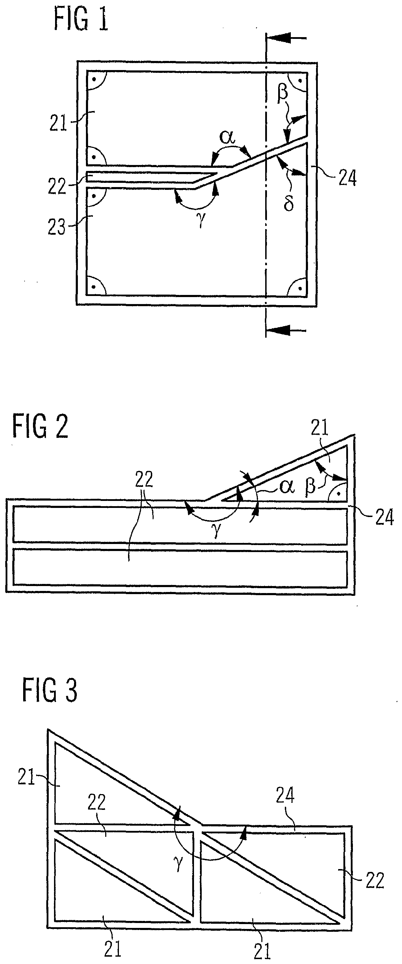

Der in Figur 1 dargestellte Lumineszenzdiodenchip weist einen ersten Emissionsbereich 21, einen zweiten Emissionsbereich 22 und einen dritten Emissionsbereich 23 auf. Die Emissionsbereiche sind auf einem gemeinsamen Trägersubstrat 24 angeordnet.

Der erste Emissionsbereich 21 und der zweite Emissionsbereich 23 weisen in der dargestellten Draufsicht auf ihre Haupterstreckungsebene eine fünfeckige Form auf. Die fünfeckige Form des ersten Emissionsbereichs 21 weist drei rechte Winkel und zwei stumpfe Winkel α, β auf. Der dritte Emissionsbereich 23 umfasst ebenfalls drei rechte Winkel. Darüber hinaus weist er jedoch einen überstumpfen Winkel γ und einen spitzen Winkel δ auf. Unter einem "Winkel einer Form des Emissionsbereichs" ist ein Winkel gemeint, in dem zwei benachbarte Teilgeraden der Kontur der Form zueinander stehen, wobei der Winkel im Inneren der Form gemessen wird, wie in Figur 1 dargestellt.

Der überstumpfe Winkel γ beträgt beispielsweise zwischen einschließlich 185° und einschließlich 205°. Bevorzugt beträgt der überstumpfe Winkel γ etwa 195°.

Der zweite Emissionsbereich 22 weist eine viereckige Form mit zwei rechten Winkeln, einem spitzen Winkel und einem stumpfen Winkel auf. Er ist zwischen dem ersten Emissionsbereich 21 und dem dritten Emissionsbereich 23 angeordnet.

In ihrer Gesamtanordnung ergeben die drei Emissionsbereiche 21, 22, 23 eine im Wesentlichen rechteckige, insbesondere eine quadratische Form. Außenseiten der Emissionsbereiche 21, 22, 23, die einander zugewandt sind, verlaufen im Wesentlichen parallel zueinander. Die Emissionsbereiche lassen sich unabhängig voneinander in Betrieb nehmen.

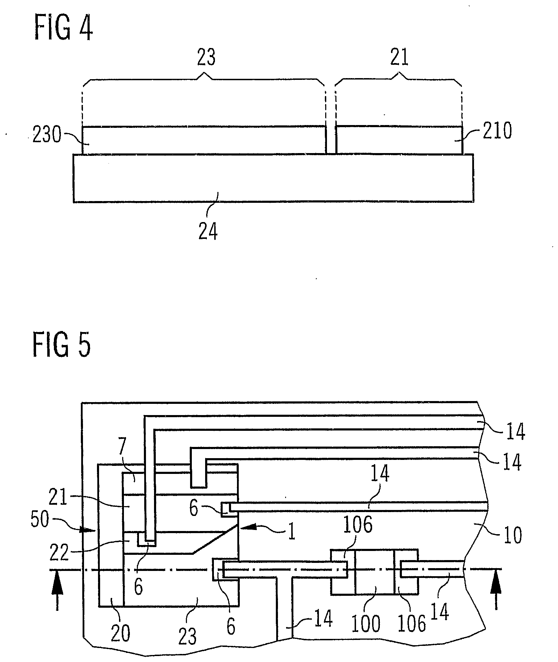

In Figur 4 ist eine schematische Schnittansicht auf einen entlang der in Figur 1 eingezeichneten gestrichelten Linie verlaufenden Schnitt dargestellt. Wie in dieser Schnittansicht zu sehen ist, werden die Emissionsbereiche 21, 23 durch Lumineszenzdiodenschichten 210, 230 gebildet. Die Lumineszenzdiodenschichten 210, 230 sind beispielsweise Halbleiterschichtenfolgen mit einer aktiven Zone, die geeignet ist, bei Beaufschlagung mit einem elektrischen Strom eine elektromagnetische Strahlung zu emittieren.

Die Lumineszenzdiodenschichten basieren beispielsweise auf Nitrid-Verbindungshalbleitermaterialien und sind geeignet, eine elektromagnetische Strahlung aus dem blauen und/oder ultravioletten Spektrum zu emittieren. Nitrid-Verbindungshalbleitermaterialien sind Verbindungshalbleitermaterialien, die Stickstoff enthalten, wie Materialien aus dem System InₓAl_{y}Ga_{1-x-y}N mit 0 ≤ x ≤ 1, 0 ≤ y ≤ 1 und x + y ≤ 1. Die Lumineszenzdiodenschichten weisen z . B. mindestens eine Halbleiterschicht aus einem Nitrid-Verbindungshalbleitermaterial auf.

In den Lumineszenzdiodenschichten können beispielsweise ein herkömmlicher pn-Übergang, eine Doppelheterostruktur, eine Einfach-Quantentopfstruktur (SQW-Struktur) oder eine Mehrfach-Quantentopfstruktur (MQW-Strukur) enthalten sein. Solche Strukturen sind dem Fachmann bekannt und werden von daher an dieser Stelle nicht näher erläutert. Beispiele für solche MQW-Strukturen sind in den Druckschriften US 5,831,277 und US 5,684,309 beschrieben.

Die Lumineszenzdiodenschichten 210, 230 sind auf einem Substrat 24 aufgebracht. Dabei kann es sich um ein Aufwachssubstrat handeln, auf dem die Lumineszenzdiodenschichten in Form einer Halbleiterschichtenfolge aufgewachsen ist. Alternativ kann das Substrat 24 auch ein Trägersubstrat sein, auf dem die Lumineszenzdiodenschichten 210, 230 nach ihrer Ausbildung aufgebracht worden sind.

In diesem Fall kann beispielsweise zwischen den Lumineszenzdiodenschichten 210, 230 und dem Substrat 24 ein Reflektor angeordnet sein, der elektromagnetische Strahlung, die in den Lumineszenzdiodenschichten 210, 230 erzeugt werden, reflektiert. Es kann sich hierbei beispielsweise um einen metallischen oder dielektrischen Spiegel handeln. Bevorzugt umfasst der Reflektor eine dielektrische Schicht und eine auf dieser dielektrischen Schicht aufgebrachte metallische Schicht, wobei die dielektrische Schicht an die Lumineszenzdiodenschichten 210, 230 angrenzt (nicht gezeigt).

Die Lumineszenzdiodenschichten 210, 230 sind voneinander beabstandet. Dadurch lassen sich ihre Emissionsbereiche 21, 23 unabhängig voneinander ansteuern. Die Realisierung einer voneinander unabhängigen Ansteuerbarkeit verschiedener Emissionsbereiche kann jedoch auch auf beliebige andere Weise erfolgen. Es ist beispielsweise auch möglich, dass die Emissionsbereiche entlang der ihnen zugeordneten Haupterstreckungsebene teilweise miteinander überlappen, das heißt die Emissionsbereiche müssen nicht in physikalisch voneinander getrennten Bereichen angeordnet sein.

Teilweise überlappende Emissionsbereiche lassen sich beispielsweise durch Strombarrieren erreichen, durch die ein elektrischer Strom, der beispielsweise in einem ersten Emissionsbereich eingeprägt wird, nur teilweise daran gehindert wird, Bereiche einer Lumineszenzdiodenschicht zu durchfließen, die einem zweiten Emissionsbereich zugeordnet ist. Die Strombarriere oder die Strombarrieren bewirken auch bei Bestromung des zweiten Emissionsbereichs eine entsprechende teilweise Abschirmung des elektrischen Stroms. Insgesamt lassen sich auf diese Weise zwei unterschiedliche, jedoch teilweise miteinander überlappende Emissionsbereiche realisieren.

Der in Figur 2 dargestellte Lumineszenzdiodenchip weist einen ersten Emissionsbereich 21 und zwei zweite Emissionsbereiche 22 auf. Der erste Emissionsbereich 21 hat eine dreieckige Form mit einem rechten Winkel und zwei spitzen Winkeln α, β. Die zwei zweiten Emissionsbereiche 22 weisen eine lang gestreckte rechteckige Form auf. Sie sind derart nebeneinander angeordnet, dass zwei ihrer Längsseiten parallel zueinander verlaufen und einander zugewandt sind. Der erste Emissionsbereich 21 ist derart relativ zu den zwei zweiten Emissionsbereichen 22 angeordnet, dass durch die Gesamtanordnung der Emissionsbereiche eine fünfeckige Form mit einem überstumpfen Winkel γ gebildet ist. Der überstumpfe Winkel γ kann wie der überstumpfe Winkel des dritten Emissionsbereichs des in Figur 1 dargestellten Lumineszenzdiodenchips beschaffen sein.

Der in Figur 3 dargestellte Lumineszenzdiodenchip weist fünf gleichartig geformte Emissionsbereiche 21, 22 auf. Die Formen von drei ersten Emissionsbereichen 21 weisen eine erste Orientierung auf und die Formen von zwei zweiten Emissionsbereichen 22 weisen eine zweite Orientierung auf, wobei die erste Orientierung parallel zur Haupterstreckungsebene der Emissionsbereiche um 180° gegenüber der zweiten Orientierung gedreht ist.

Die Emissionsbereiche weisen alle eine dreieckige Form mit einem rechten Winkel und zwei spitzen Winkeln auf. Die Gesamtanordnung der Emissionsbereiche ergibt wiederum eine fünfeckige Form mit einem überstumpfen Winkel γ, der wie die in den vorangehenden Beispielen beschriebenen überstumpfen Winkel γ beschaffen sein kann.

Die in den Figuren 1 bis 3 dargestellten Lumineszenzdiodenchips weisen eine gute Eignung für die Verwendung in einem Scheinwerfermodul für Kraftfahrzeug-Frontscheinwerfer auf. Für derartige Frontscheinwerfer ist in vielen Ländern eine unsymmetrische Abstrahlcharakteristik vorgeschrieben, bei der emittierte Scheinwerferkegel einen unsymmetrischen Querschnitt mit einem überstumpfen Winkel aufweisen.

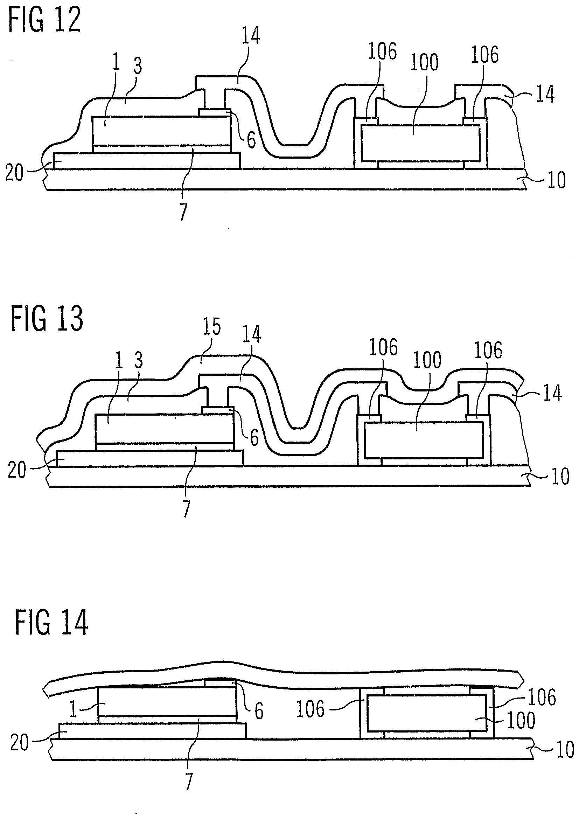

Der in Figur 5 dargestellte optoelektronische Scheinwerfer weist ein optoelektronisches Bauelement 50 und ein passives Bauelement 100 auf. Diese verschiedenartigen elektrischen Bauelemente sind auf einem Trägerkörper 10 angeordnet. Wie in der Schnittansicht von Figur 13 zu erkennen ist, sind die Bauelemente 50, 100 und der Trägerkörper 10 mit einer elektrischen Isolierschicht 3 bedeckt. Auf der Isolierschicht 3 ist eine elektrische Leiterbahnstruktur 14 ausgebildet. Das optoelektronische Bauelement 50 und das passive elektrische Bauelement 100 weisen elektrische Anschlussflächen 7, 6, 106 auf, die mit der Leiterbahnstruktur 14 verbunden sind.

Das optoelektronische Bauelement 50 weist einen Chipträger 20 mit einer elektrischen Anschlussfläche 7 auf. Auf einem Teil der elektrischen Anschlussfläche 7 ist ein Lumineszenzdiodenchip 1 aufgebracht. Dieser weist auf einer der elektrischen Anschlussfläche 7 des Chipträgers 20 abgewandten Seite drei Emissionsbereiche 21, 22, 23 mit jeweils einer elektrischen Anschlussfläche 6 auf. Diese elektrischen Anschlussflächen 6 und der von dem Lumineszenzdiodenchip 1 nicht bedeckte Teil der elektrischen Anschlussfläche 7 bilden jeweils elektrische Anschlussflächen des optoelektronischen Bauelements 50.

Das passive Bauelement 100 ist beispielsweise ein Widerstand, ein Varistor oder ein Kondensator. Eine seiner elektrischen Anschlussflächen 106 ist über eine elektrische Leiterbahn der Leiterbahnstruktur 14 elektrisch leitend mit der elektrischen Anschlussfläche 6 des dritten Emissionsbereichs 23 des Lumineszenzdiodenchips 1 verbunden. Die zweite elektrische Anschlussfläche 106 ist ebenfalls mit einer Leiterbahn der Leiterbahnstruktur 14 elektrisch leitend verbunden, wobei diese Leiterbahn jedoch nicht unmittelbar zu einer Anschlussfläche des optoelektronischen Bauelements 50, sondern von diesem weg führt.

Auch die Anschlussflächen 6 des ersten Emissionsbereichs 21 und des zweiten Emissionsbereichs 22 sowie die auf dem Chipträger 20 ausgebildete elektrische Anschlussfläche 7 des optoelektronischen Bauelements 50 sind mit einer Leiterbahn der Leiterbahnstruktur 14 elektrisch leitend verbunden. Die elektrischen Anschlussflächen 6, 7, 106 sind bevorzugt alle sowohl elektrisch leitend als auch mechanisch unmittelbar mit der Leiterbahnstruktur 14 verbunden.

Der in Figur 5 dargestellte Scheinwerfer kann beispielsweise mit einem Trägerkörper 10 gefertigt sein, der keine elektrischen Leiterbahnen oder elektrischen Anschlussflächen aufweist. Sämtliche elektrische Leiterbahnen des Scheinwerfers sind beispielsweise mit Vorteil als ein Teil der Leiterbahnstruktur 14 auf der isolierenden Schicht 3 ausgebildet.

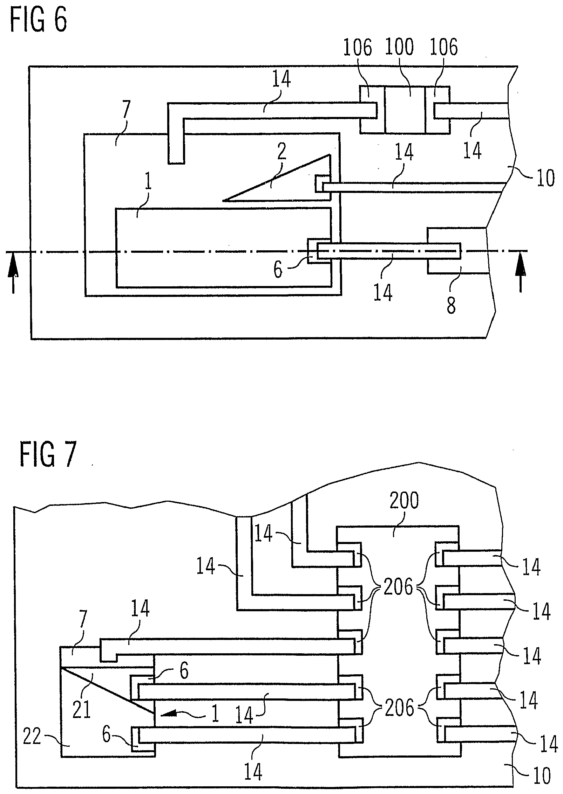

Alternativ ist es auch möglich, die auf der isolierenden Schicht 3 ausgebildete Leiterbahnstruktur 14 mit Leiterbahnen und/oder Anschlussflächen eines entsprechenden Trägerkörpers 10 zu kombinieren, das heißt die elektrische Verschaltung der Bauelemente umfasst sowohl die Leiterbahnstruktur 14 als auch Leiterbahnen und/oder Anschlussflächen des Trägerkörpers 10. Ein Beispiel für einen derartigen Scheinwerfer ist in Figur 6 dargestellt.

Der in Figur 6 dargestellte Scheinwerfer weist einen Trägerkörper 10 mit einer elektrischen Anschlussfläche 7 auf, auf der ein erster Lumineszenzdiodenchip 1 und ein zweiter Lumineszenzdiodenchip 2 aufgebracht ist. Der erste Lumineszenzdiodenchip 1 weist einen einzigen Emissionsbereich mit einer in Draufsicht auf seine Haupterstreckungsebene rechteckigen Form auf. Der zweite Lumineszenzdiodenchip 2 weist einen einzigen Emissionsbereich mit einer in Draufsicht auf seine Haupterstreckungsebene dreieckigen Form auf. Der Abstand zwischen den Lumineszenzdiodenchips beträgt z.B. etwa 20 µm.

Die der elektrischen Anschlussfläche 7 zugewandte Seite der Lumineszenzdiodenchips 1,2 sind elektrisch leitfähig mit der Anschlussfläche 7 verbunden. Die der elektrischen Anschlussfläche 7 abgewandte Seiten der Lumineszenzdiodenchips 1, 2 weisen jeweils eine elektrische Anschlussfläche 6 auf, die mit einer Leiterbahn der Leiterbahnstruktur 14 elektrisch leitend verbunden ist. Die Anschlussfläche 6 des ersten Lumineszenzdiodenchips 1 ist über die Leiterbahnstruktur elektrisch leitend mit einem elektrischen Anschlussbereich 8 des Trägerkörpers 10 verbunden.

Eine weitere Leiterbahn der Leiterbahnstruktur 14 verbindet die elektrische Anschlussfläche 7 mit einer Anschlussfläche 106 eines ebenfalls auf dem Trägerkörper 10 befindlichen passiven Bauelements 100. Dieses passive Bauelement 100 weist zwei elektrische Anschlussflächen 106 auf, wobei auch die zweite elektrische Anschlussfläche mit einer Leiterbahn der Leiterbahnstruktur 14 elektrisch leitend verbunden ist.

Es ist zum Beispiel möglich, dass die Leiterbahnstruktur 14 keine Leiterbahnen aufweist, die elektrische Anschlussflächen von Bauelementen des Scheinwerfers unmittelbar elektrisch leitend miteinander verbindet.

Bei den in den Figuren 5 und 6 dargestellten Ausschnitten eines Scheinwerfers können bevorzugt mehrere Lumineszenzdiodenchips verwendet werden. Beispielsweise sind zwischen einschließlich vier und einschließlich zehn Lumineszenzdiodenchips enthalten. Alternativ weist der Scheinwerfer beispielsweise zwischen einschließlich vier und einschließlich zehn optoelektronische Bauelemente auf, die jeweils mindestens einen Lumineszenzdiodenchip 1 enthalten.

Bei derartigen Scheinwerfern dienen die passiven Bauelemente beispielsweise zur Stabilisierung der an die optoelektronischen Bauelemente angelegten elektrischen Spannung. Hierfür werden zweckmäßigerweise Varistoren verwendet. Zusätzlich oder alternativ können weitere elektrische Bauelemente, die zu den optoelektronischen Bauelementen 50 verschiedenartig sind, für beliebige Zwecke wie beispielsweise zur Ausbildung geeigneter elektrischer Ansteuerungsschaltungen in dem Scheinwerfer enthalten sein. Dies umfasst insbesondere auch logische Schaltkreise, die unter Verwendung integrierter Schaltkreise gebildet sind.

Beispielsweise können Logikchips und/oder Speicherchips auf dem Trägerkörper 10 angeordnet und mit der Leiterbahnstruktur 14 elektrisch leitend verbunden sein.

Ein Ausschnitt eines beispielhaften Scheinwerfers , der einen integrierten Schaltkreis 200 aufweist, ist in Figur 7 dargestellt. Der integrierte Schaltkreis 200 ist beispielsweise mit einem Gehäuse versehen und geeignet, ähnlich wie ein SMD-Bauelement montiert und angeschlossen zu werden. Zusätzlich oder alternativ können auch integrierte Schaltkreise ohne Gehäuse ("bare dies") verwendet werden. Derartige bare dies werden in der Regel mittels Kleben oder Auflöten mechanisch montiert und durch einen wire bonding-Prozess elektrisch leitend angeschlossen. Darüber hinaus können auch integrierte Schaltkreise verwendet werden, die geeignet sind, über eine Bump-Montage angeschlossen zu werden.

Bei dem in Figur 7 dargestellten Scheinwerfer ist ein derartiger integrierter Schaltkreis 200 auf dem Trägerkörper 10 aufgebracht und unter Verwendung der auf einer Isolierschicht 3 aufgebrachten Leiterbahnstruktur 14 elektrisch leitend angeschlossen. Beispielsweise sind alle elektrischen Anschlussflächen 206 des integrierten Schaltkreises 200 unmittelbar elektrisch leitend mit Leiterbahnen der Leiterbahnstruktur 14 verbunden.

Auf dem Trägerkörper 10 ist ein Lumineszenzdiodenchip 1 mit einem ersten und einem zweiten nicht rechteckigen Emissionsbereich 21, 22 aufgebracht. Der erste Emissionsbereich 21 ist dreieckig, der zweite Emissionsbereich ist viereckig. Sie weisen jeweils eine elektrische Anschlussfläche 6 auf. Eine weitere Anschlussfläche 7 zum elektrischen Anschließen des Lumineszenzdiodenchips ist neben dem Chip auf dem Trägerkörper 10 angeordnet. Die elektrischen Anschlüsse 6, 7 sind über Leiterbahnen der Leiterbahnstruktur elektrisch leitend mit Anschlussflächen des integrierten Schaltkreises 200 verbunden.

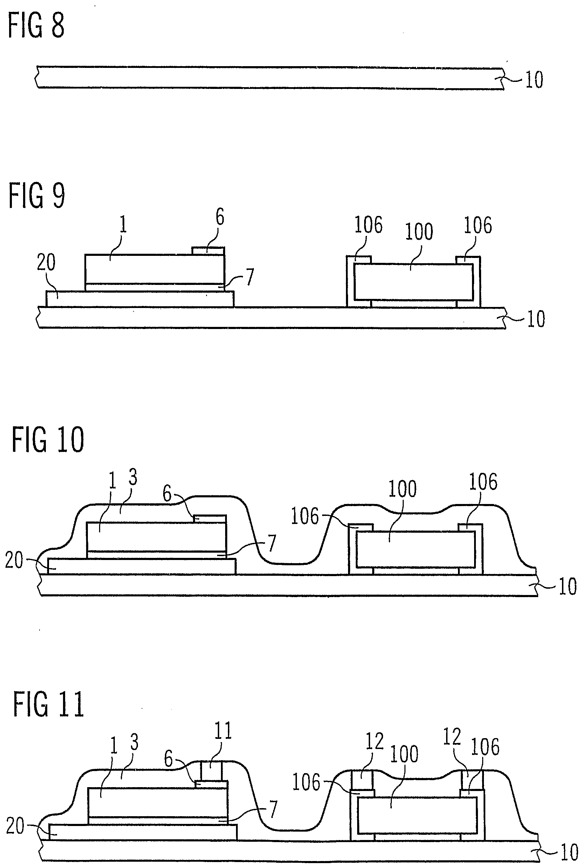

Die isolierende Schicht ist aus Gründen der Übersichtlichkeit in den Figuren 5, 6 und 7 nicht dargestellt. Sie ist zwischen der Leiterbahnstruktur 14 und den übrigen in den Figuren dargestellten Elementen angeordnet, wobei die isolierende Schicht in den Bereichen der zu kontaktierenden Anschlussflächen Ausnehmungen für Durchkontaktierungen aufweist. Verdeutlicht wird dieser Aufbau durch die nachfolgende Beschreibung beispielhafter Verfahren zur Herstellung eines Scheinwerfers mit Einbeziehung der Figuren 8 bis 21.

In den Figuren 8 bis 13 sind schematische Schnittansichten verschiedener Verfahrensstadien eines beispielhaften Verfahrens zur Herstellung des in Figur 5 dargestellten Scheinwerfers enthalten. Die in Figur 13 dargestellte Schnittansicht ist eine Darstellung auf einen Schnitt entlang der in Figur 5 eingezeichneten gestrichelten Linie. Die in den Figuren 8 bis 12 dargestellten Schnittansichten sind Darstellungen eines entsprechenden Schnittes während vorhergehender Verfahrensstadien des beispielhaften Verfahrens.

In Figur 8 ist der Verfahrensschritt einer Bereitstellung eines Trägerkörpers 10 dargestellt. Der Trägerkörper 10 weist beispielsweise die Form einer ebenen Platte auf. Alternativ kann der Trägerkörper auch Strukturen und Unebenheiten aufweisen. Er enthält zum Beispiel ein keramisches Material, einen Kunststoff und/oder ein Metall oder besteht im Wesentlichen aus einem dieser Materialien. Beispielsweise besteht der Trägerkörper aus Aluminiumnitrid.

Auf den Trägerkörper 10 werden mindestens zwei verschiedenartige elektrische Bauelemente 50, 100 aufgebracht, siehe Figur 9. Zweckmäßigerweise werden diese Bauelemente an dem Trägerkörper 10 befestigt. Obgleich eine elektrisch leitende Anbindung der Bauelemente an den Trägerkörper 10 nicht erforderlich ist, kann eine Verbindung mit einer hohen Wärmeleitfähigkeit zwischen den Bauelementen und dem Trägerkörper 10 vorteilhaft sein. Die Bauelemente 50, 100 sind beispielsweise mittels Klebstoff und/oder mittels eines Lotes mit dem Trägerkörper 10 verbunden. Auf eine derartige Verbindung kann jedoch grundsätzlich auch verzichtet werden.

Eines der Bauelemente ist ein optoelektronisches Bauelement 50, das einen Chipträger 20, eine auf dem Chipträger 20 aufgebrachte elektrische Anschlussschicht 7 und einen auf der elektrischen Anschlussschicht 7 aufgebrachten Lumineszenzdiodenchip 1 umfasst.

Der Lumineszenzdiodenchip 1 weist auf seiner der elektrischen Anschlussschicht 7 zugewandten Außenfläche eine elektrische Anschlussfläche auf, die beispielsweise mittels Anlöten elektrisch leitend und mechanisch mit der elektrischen Anschlussschicht 7 verbunden ist (nicht dargestellt). Auf einer der elektrischen Anschlussschicht 7 abgewandten Seite weist der Lumineszenzdiodenchip 1 eine elektrische Anschlussfläche 6 auf. Die Anschlussfläche 6 wird zum Beispiel durch eine Kontaktschicht oder eine Kontaktschichtenfolge gebildet, die auf einer Lumineszenzdiodenschicht des Lumineszenzdiodenchips 1 aufgebracht und beispielsweise mittels Fotolithografie strukturiert ist.

Der Chipträger 20 weist mindestens eines der Materialien Keramik, Metall und Kunststoff auf oder besteht aus einem dieser Materialien. Beispielsweise besteht er aus Aluminiumnitrid.

In einem Abstand zu dem optoelektronischen Bauelement 50 wird auf dem Trägerkörper 10 ein passives Bauelement 100 aufgebracht. Das Bauelement weist zwei elektrische Anschlussflächen 106 auf, die derart ausgebildet sind, dass das Bauelement 100 für eine SMD-Montage geeignet ist. SMD steht für "surface mountable device". Unter einer SMD-Montage ist eine für SMD-Bauelemente typische Montage zu verstehen, die in der Regel ein Aufbringen des Bauelements auf eine Montagefläche und ein Verlöten elektrischer Anschlussflächen des Bauelements mit Anschlussflächen auf der Montagefläche umfasst.

Bei dem in Figur 10 veranschaulichten Verfahrensstadium wird auf die elektrischen Bauelemente 50, 100 und auf den Trägerkörper 10 eine Isolierschicht 3 aufgebracht. Das Aufbringen der Isolierschicht 3 erfolgt vorzugsweise durch Aufsprühen oder Aufschleudern (Spincoating) einer Polymerlösung. Weiterhin kann beispielsweise auch ein Druckverfahren, insbesondere Siebdruck, zum Aufbringen der Isolierschicht 3 mit Vorteil verwendet werden.

Bei dem in Figur 11 veranschaulichten Verfahrensschritt werden eine erste Ausnehmung 11, durch die ein Teilbereich der elektrischen Anschlussfläche 6 des Lumineszenzdiodenchips 1 freigelegt wird, und zwei zweite Ausnehmungen 12, durch die jeweils ein Teilbereich der elektrischen Anschlussflächen 106 des passiven Bauelements 100 freigelegt werden, in der Isolierschicht 3 erzeugt. Die Ausnehmungen 11, 12 werden beispielsweise mittels eines lithografischen Prozesses oder mittels einer Laserbearbeitung erzeugt, wobei eine Laserbearbeitung bevorzugt ist.

Nachfolgend wird elektrisch leitfähiges Material derart auf die Isolierschicht aufgebracht, dass es mit den elektrischen Anschlussflächen 6, 106 verbunden ist. Zweckmäßigerweise wird das elektrisch leitfähige Material derart aufgebracht, dass es die Ausnehmungen 11, 12 füllt und die Isolierschicht 3 bedeckt. Es wird zur Ausbildung einer elektrischen Leiterbahnstruktur 14 aufgebracht, wie in Figur 12 dargestellt.

Das elektrisch leitfähige Material weist zum Beispiel mindestens ein Metall auf oder besteht aus einem solchen. Es wird beispielsweise in Form einer Metallschicht aufgebracht. Dies erfolgt zum Beispiel durch Aufdampfen oder Sputtern. Nachfolgend wird die Metallschicht strukturiert, was beispielsweise mittels Fotolithografie erfolgt.

Alternativ wird zunächst eine vergleichsweise dünne Metallschicht, die beispielsweise 100 nm dick ist, ganzflächig auf die Isolierschicht 3 aufgebracht. Die Metallschicht wird in Bereichen, die zur Ausbildung der Leiterbahnstruktur 14 vorgesehen sind, selektiv galvanisch verstärkt und nachfolgend so lange geätzt, bis die unverstärkten Bereiche abgetragen sind. Dies erfolgt beispielsweise durch Aufbringen einer Fotolackschicht auf die Metallschicht, in der mittels Fototechnik Ausnehmungen in den für die Leiterbahnstruktur 14 vorgesehenen Bereichen erzeugt werden (nicht gezeigt).

In dem Bereich der Ausnehmungen in der Fotolackschicht wird die zuvor aufgebrachte Metallschicht durch eine galvanische Abscheidung verstärkt. Dies erfolgt vorteilhaft derart, dass die Metallschicht in dem galvanisch verstärkten Bereich wesentlich dicker ist als die zuvor ganzflächig aufgebrachte Metallschicht. Beispielsweise kann die Dicke der Metallschicht in dem galvanisch verstärkten Bereich mehrere Mikrometer betragen. Nachfolgend wird die Fotolackschicht entfernt und ein Ätzprozess durchgeführt, mit dem die Metallschicht in nicht galvanisch verstärkten Bereichen vollständig abgetragen wird. In den galvanisch verstärkten Bereichen wird die Metallschicht aufgrund ihrer größeren Dicke dagegen nur teilweise abgetragen, sodass sie in diesen Bereichen zur Bildung der elektrischen Leiterbahnstruktur 14 verbleibt.

Als weitere Alternative ist es auch möglich, dass die elektrische Leiterbahnstruktur direkt in einer strukturierten Form auf die Isolierschicht 3 aufgebracht wird. Dies kann beispielsweise unter Verwendung eines Druckverfahrens, insbesondere unter Verwendung eines Siebdruckverfahrens, erfolgen.

Alternativ zu einem Metall wird beispielsweise mit Vorteil ein transparentes elektrisch leitfähiges Material verwendet, das insbesondere für eine von dem Lumineszenzdiodenchip 1 emittierte elektromagnetische Strahlung durchlässig ist. Als ein derartiges elektrisch leitfähiges transparentes Material ist insbesondere ein transparentes leitfähiges Oxid (TCO) wie beispielsweise ein Indium-Zinn-Oxid. (ITO) geeignet. Alternativ wird beispielsweise eine transparente elektrisch leitfähige Kunststoffschicht verwendet. Das elektrisch leitfähige transparente Material wird vorzugsweise durch Aufdampfen, Aufdrucken, Aufsprühen oder Aufschleudern (Spincoating) aufgebracht.

Nach dem Ausbilden der elektrischen Leiterbahnstruktur 14, siehe Figur 12, kann in einem optionalen weiteren Verfahrensschritt eine elektrisch isolierende Deckschicht 15 auf die Leiterbahnstruktur aufgebracht werden, siehe Figur 13. Die isolierende Deckschicht 15 ist vorzugsweise eine Kunststoffschicht, zum Beispiel eine Lackschicht. Sie bedeckt insbesondere die Leiterbahnstruktur 14, um eine potentialfreie Oberfläche zu erzeugen.

Eine alternative Variante des Aufbringens der Isolierschicht 3, wie es vorhergehend unter Bezugnahme auf Figur 10 erläutert ist, ist in Figur 14 veranschaulicht. Hierbei wird die elektrisch isolierende Schicht vor dem Aufbringen auf den Trägerkörper 10 vorgefertigt. Beispielsweise wird sie in Form einer flexiblen Folie bereitgestellt, die nachfolgend auf die Bauelemente und den Trägerkörper 10 aufgebracht wird. Die Folie lässt sich beispielsweise unter Verwendung eines Klebstoffes aufkleben oder auflaminieren. Im Übrigen kann die Durchführung des Verfahrens wie vorhergehend beschrieben erfolgen.

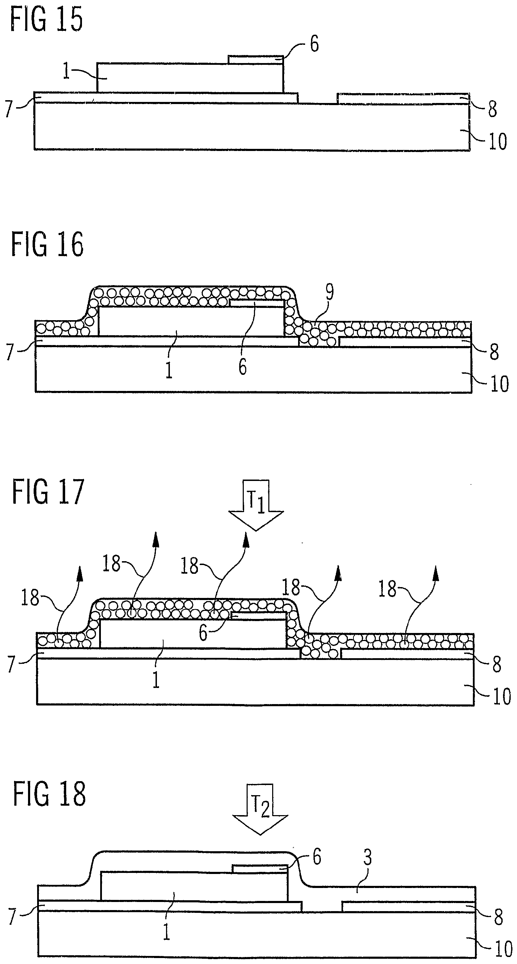

Eine weitere alternative Variante des Aufbringens der Isolierschicht 3 wird nachfolgend im Rahmen der Beschreibung des anhand der Figuren 15 bis 18 veranschaulichten Ausführungsbeispiels des Verfahrens erläutert.

Im Unterschied zu dem vorhergehend anhand der Figuren 8 bis 14 erläuterten Verfahren wird ein Trägerkörper 10 bereitgestellt, der zwei Anschlussbereiche 7, 8 aufweist. Die elektrischen Anschlussbereiche 7, 8 sind elektrisch voneinander isoliert. Sie sind beispielsweise durch Metallschichten gebildet, die auf einem Grundkörper des Trägerkörpers 10 aufgebracht sind. Der Trägerkörper 10 kann beispielsweise ein PCB (printed circuit board), insbesondere ein MCPCB sein.

Auf dem ersten Anschlussbereich 7 ist ein Lumineszenzdiodenchip 1 aufgebracht und elektrisch leitend mit dem Anschlussbereich 7 verbunden, was beispielsweise durch Anlöten oder Aufkleben der dem Anschlussbereich zugewandten Fläche des Lumineszenzdiodenchips mittels eines Lotes oder eines elektrisch leitfähigen Klebstoffes erfolgt. Auf seiner dem Anschlussbereich 7 abgewandten Seite weist der Lumineszenzdiodenchip 1 eine elektrische Anschlussfläche 6 auf. Der Lumineszenzdiodenchip 1 ist ein Beispiel für ein optoelektronisches Bauelement, das auf dem Trägerkörper 10 aufgebracht wird.

Alternativ kann das optoelektronische Bauelement auch ein Gehäuse aufweisen, in dem der Lumineszenzdiodenchip 1, gegebenefalls gemeinsam mit dem in Figur 6 dargestellten zweiten Lumineszenzdiodenchip 2, montiert ist und gegebenenfalls auch eingekapselt ist. Das Gehäuse kann beispielsweise für eine SMD-Montage geeignet sein.

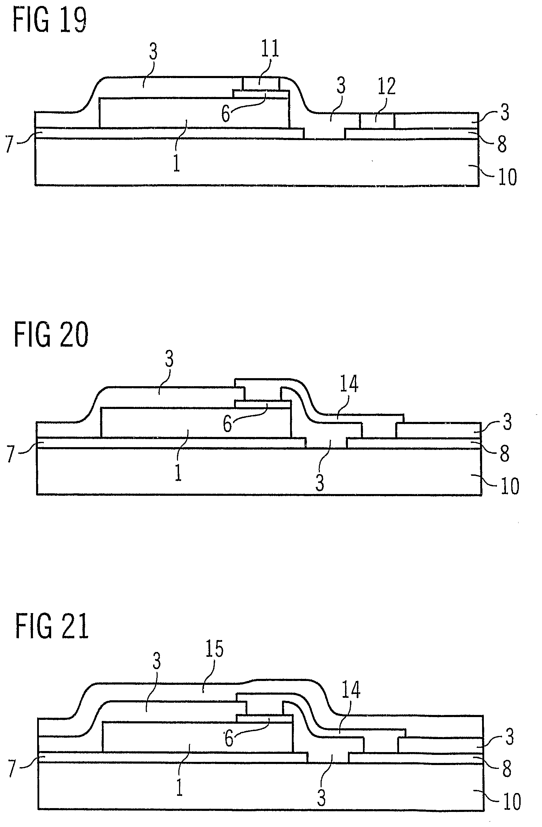

Die Figuren 15 bis 21 entsprechen Darstellungen eines Schnittes des in Figur 6 dargestellten Scheinwerfers entlang der in Figur 6 eingetragenen gestrichelten Linie während verschiedenen Verfahrensstadien zur Herstellung des Scheinwerfers. Die in Figur 21 dargestellte Schnittansicht entspricht einer Darstellung des Schnittes durch den fertigen Scheinwerfer.

Auf den Trägerkörper 10 und die darauf aufgebrachten Bauelemente wird eine Precursor-Schicht 9 aufgebracht, die sowohl organische als auch anorganische Bestandteile enthält, siehe Figur 16. Das Aufbringen der Precursor-Schicht erfolgt beispielsweise mittels eines Sol-Gel-Verfahrens, durch Aufdampfen, Sputtern, Aufsprühen oder durch Aufschleudern (Spincoating) einer Suspension.

Nachfolgend wird die Precursor-Schicht einer ersten Temperaturbehandlung unterzogen. Dabei wird sie beispielsweise bei einer Temperatur T₁ von vorzugsweise etwa 200° C bis 400° C für etwa vier Stunden bis acht Stunden in einer neutralen oder geringfügig sauerstoffhaltigen Atmosphäre belassen. Hierfür eignet sich beispielsweise eine reine Stickstoffatmosphäre oder eine neutrale Atmosphäre, die einen geringen Sauerstoff-Partialdruck aufweist. Bei dieser ersten Temperaturbehandlung werden organische Bestandteile der Precursor-Schicht 9 entfernt, wie in Figur 17 durch die Pfeile 18 angedeutet ist.

Die so entstandene Schicht wird nachfolgend, wie in Figur 18 schematisch dargestellt ist, mit einer zweiten Temperaturbehandlung verdichtet, um die Isolierschicht 3 herzustellen. Die zweite Temperaturbehandlung umfasst ein Sintern, das bei einer Temperatur T₂ von vorzugsweise etwa 300° C bis 500° C für etwa vier Stunden bis fünf Stunden erfolgt. Die zweite Temperaturbehandlung wird vorzugsweise unter einer reduzierenden oder einer oxidierenden Atmosphäre durchgeführt. Durch dieses Verfahren lassen sich insbesondere Glasschichten erzeugen.

Die so hergestellte Isolierschicht 3 wird nachfolgend mit Ausnehmungen 11, 12 versehen, um Teilbereiche elektrischer Anschlussflächen 6 oder elektrische Anschlussbereiche des Trägerkörpers 8 freizulegen, siehe Figur 19. Nachfolgend wird auf die isolierende Schicht 3 ein elektrisch leitfähiges Material zur Ausbildung einer Leiterbahnstruktur 14 aufgebracht, siehe Figur 20. Auf die elektrische Leiterbahnstruktur 14 wird nachfolgend optional eine isolierende Deckschicht 15 aufgebracht, was in Figur 21 veranschaulicht ist.

Die Herstellung der Deckschicht 15 kann in analoger Weise wie die Herstellung der Isolierschicht 3 erfolgen. Sie kann insbesondere ein Glas aufweisen oder aus einem Glas bestehen. In diesem Fall werden die vorhergehend anhand der Figuren 16 bis 18 beschriebenen Verfahrensschritte bevorzugt ein erstes Mal durchgeführt, um eine Isolierschicht 3 zu erzeugen, und nach dem Aufbringen der Leiterbahnstruktur 14 wiederholt, um die Deckschicht 15 auszubilden.

Durch eine mehrfache Wiederholung des Aufbringens einer elektrisch isolierenden Schicht und einer elektrisch leitfähigen Schicht kann auch eine mehrlagige Leiterbahnstruktur realisiert werden. Dies ist insbesondere vorteilhaft, wenn eine komplexe Verschaltung mehrerer elektrischer Bauelemente auf engem Raum realisiert werden soll.

Bei den beschriebenen Verfahren und optoelektronischen Scheinwerfern kann die isolierende Schicht und/oder die isolierende Deckschicht ein Lumineszenz-Konversionsmaterial aufweisen. Dieses liegt beispielsweise als mindestens ein Leuchtstoff in Form eines Pulvers vor. Geeignete Lumineszenz-Konversionsmaterialien sind beispielsweise alle für die Anwendung bei LEDs bekannten Konverter,

Beispiele für derartige als Konverter geeignete Leuchtstoffe und Leuchtstoffmischungen sind:
- Chlorosilikate, wie beispielsweise in DE 100 36 940 A1 und dem dort beschriebenen Stand der Technik offenbart,
- Orthosilikate, Sulfide, Thiometalle und Vanadate wie beispielsweise in WO 00/33390 A1 und dem dort beschriebenen Stand der Technik offenbart,
- Aluminate, Oxide, Halophosphate, wie beispielsweise in US 6,616,862 B2 und dem dort beschriebenen Stand der Technik offenbart,
- Nitride, Sione und Sialone wie beispielsweise in DE 101 47 040 A1 und dem dort beschriebenen Stand der Technik offenbart, und
- Granate der Seltenen Erden wie YAG:Ce und der Erdalkalielemente wie beispielsweise in US 2004/0062699 A1 und dem dort beschriebenen Stand der Technik offenbart.

Die Erfindung ist nicht durch die Ausführungsbeispiele der Erfindung beschränkt, sondern durch die beigefügten Patentansprüche definiert.

## Patentansprüche

1. Elektromagnetische Strahlung emittierender, optoelektronischer Frontscheinwerfer für ein Fahrzeug, umfassend einen Lumineszenzdiodenchip (1), der mindestens zwei Emissionsbereiche (21, 22, 23) aufweist, die in einer Draufsicht auf eine ihnen zugeordnete Haupterstreckungsebene unterschiedlich geformt, unterschiedlich groß und/oder unterschiedlich orientiert sind,
wobei die Emissionsbereiche (21, 22, 23) überlappungsfrei angeordnet sind,
wobei die Emissionsbereiche (21, 22, 23) unabhängig voneinander ansteuerbar sind,
wobei der Lumineszenzdiodenchip (1) auf einem Trägerkörper (10) angeordnet und zusammen mit dem Trägerkörper (10) mit einer elektrischen Isolierschicht (3) bedeckt ist, auf der eine elektrische Leiterbahnstruktur (14) ausgebildet ist, wobei die Emissionsbereiche (21, 22, 23) jeweils mindestens eine elektrische Anschlussfläche (6) aufweisen, die mit der Leiterbahnstruktur (14) verbunden ist, und
wobei der Frontscheinwerfer ein optisches Element zur Ausbildung eines Strahlenkegels aufweist.

2. Frontscheinwerfer nach Anspruch 1,
**dadurch gekennzeichnet, dass**
die Form mindestens eines der Emissionsbereiche (21, 22, 23) in einer Draufsicht auf die Haupterstreckungsebene nicht rechteckig ist.

3. Frontscheinwerfer nach Anspruch 1 oder 2,
**dadurch gekennzeichnet, dass**
die Form mindestens eines der Emissionsbereiche (21, 22, 23) in einer Draufsicht auf die Haupterstreckungsebene eine Ecke mit einem spitzen Winkel oder mit einem stumpfen Winkel aufweist.

4. Frontscheinwerfer nach einem der vorhergehenden Ansprüche,
**dadurch gekennzeichnet, dass**
die Form mindestens eines der Emissionsbereiche (21, 22, 23) in einer Draufsicht auf die Haupterstreckungsebene einen Knick mit einem überstumpfen Winkel aufweist.

5. Frontscheinwerfer nach einem der vorhergehenden Ansprüche,
**dadurch gekennzeichnet, dass**
die Form mindestens eines der Emissionsbereiche (21, 22, 23) in einer Draufsicht auf die Haupterstreckungsebene keine Symmetrieachse aufweist.

6. Frontscheinwerfer nach einem der vorhergehenden Ansprüche,
**dadurch gekennzeichnet, dass**
benachbarte Emissionsbereiche (21, 22, 23) zueinander einen Abstand von kleiner als oder gleich 100 µm aufweisen.

7. Frontscheinwerfer nach einem der vorhergehenden Ansprüche,
**dadurch gekennzeichnet, dass**
zusätzlich zu dem Lumineszenzdiodenchip (1) ein elektronisches Bauelement (100, 200) auf dem Trägerkörper (10) angeordnet ist, das mindestens eine elektrische Anschlussfläche (106, 206) aufweist, die über die Leiterbahnstruktur (14) elektrisch leitend mit mindestens einer Anschlussfläche (6) der Emissionsbereiche (21, 22, 23) verbunden ist.

8. Frontscheinwerfer nach Anspruch 7,
**dadurch gekennzeichnet, dass**
das elektronische Bauelement (100, 200) ein passives Bauelement (100) und/oder ein integrierter Schaltkreis (200) ist.

9. Frontscheinwerfer nach einem der Ansprüche 7 oder 8,
**dadurch gekennzeichnet, dass**
das elektronische Bauelement (100, 200) für eine SMD-Montage geeignet ist.

10. Frontscheinwerfer nach einem der Ansprüche 1 bis 9,
**dadurch gekennzeichnet, dass**
die Anschlussfläche (6) mindestens eines Emissionsbereichs (21, 22, 23) mit einem Anschlussbereich (8) des Trägerkörpers (10) über die Leiterbahnstruktur (14) elektrisch leitend verbunden ist.

11. Frontscheinwerfer nach einem der Ansprüche 1 bis 10,
**dadurch gekennzeichnet, dass**
die Isolierschicht (3) ein Lumineszenz-Konversionsmaterial enthält.

12. Frontscheinwerfer nach einem der Ansprüche 1 bis 11,
**dadurch gekennzeichnet, dass**
der Lumineszenzdiodenchip (1) auf einem Chipträger (20) montiert ist, wobei der Chipträger (20) auf dem Trägerkörper (10) aufgebracht ist.

## Claims

1. Electromagnetic radiation-emitting optoelectronic front headlamp for a vehicle, comprising a luminescent diode chip (1) which has at least two emission regions (21, 22, 23) which are differently shaped, differently sized and/or differently oriented in a plan view of a main extension plane assigned to them,
wherein the emission regions (21, 22, 23) are arranged without overlapping,
wherein the emission regions (21, 22, 23) can be controlled independently of each other,
wherein the luminescent diode chip (1) is arranged on a carrier body (10) and, together with the carrier body (10), is covered with an electrically insulating layer (3) on which an electrical conductor track structure (14) is formed, the emission regions (21, 22, 23) each having at least one electrical connection area (6) which is connected to the conductor track structure (14),
and wherein the headlamp has an optical element for forming a beam cone.

2. The front headlamp according to claim 1,
**characterized in that**
the shape of at least one of the emission regions (21, 22, 23) is not rectangular in a plan view of the main extension plane.

3. The front headlamp according to claim 1 or 2,
**characterized in that**
the shape of at least one of the emission regions (21, 22, 23) has a bend with an acute angle or with an obtuse angle in a plan view of the main extension plane.

4. The front headlamp according to any of the preceding claims,
**characterized in that**
the shape of at least one of the emission regions (21, 22, 23) has a bend with an obtuse angle in a plan view of the main extension plane.

5. The front headlamp according to any of the preceding claims,
**characterized in that**
the shape of at least one of the emission regions (21, 22, 23) has no axis of symmetry in a plan view of the main extension plane.

6. The front headlamp according to any of the preceding claims,
**characterized in that**
adjacent emission regions (21, 22, 23) are less than or equal to 100 µm apart.

7. The front headlamp according to any of the preceding claims,
**characterized in that**
in addition to the luminescent diode chip (1), an electronic component (100, 200) is arranged on the carrier body (10), which has at least one electrical connection area (106, 206), which is electrically conductively connected via the conductor track structure (14) to at least one connection area (6) of the emission regions (21, 22, 23).

8. The front headlamp according to claim 7,
**characterized in that**
the electronic component (100, 200) is a passive component (100) and/or an integrated circuit (200).

9. The front headlamp according to one of claims 7 or 8,
**characterized in that**
the electronic component (100, 200) is suitable for SMD mounting.

10. The front headlamp according to any one of claims 1 to 9,
**characterized in that**
the connection area (6) of at least one emission region (21, 22, 23) is electrically conductively connected to a connection region (8) of the carrier body (10) via the conductor track structure (14).

11. The front headlamp according to any one of claims 1 to 10,
**characterized in that**
the insulating layer (3) contains a luminescence conversion material.

12. The front headlamp according to any one of claims 1 to 11,
**characterized in that**
the luminescent diode chip (1) is mounted on a chip carrier (20), the chip carrier (20) being applied to the carrier body (10) .

## Revendications

1. Phare avant optoélectronique émettant un rayonnement électromagnétique pour un véhicule, comprenant une puce de diode luminescente (1) présentant au moins deux zones d'émission (21, 22, 23) de forme, de taille et/ou d'orientation différentes dans une vue en plan d'un plan d'extension principal qui leur est associé,
les zones d'émission (21, 22, 23) étant disposées sans se chevaucher,
les zones d'émission (21, 22, 23) pouvant être commandées indépendamment les unes des autres,
la puce de diode luminescente (1) étant disposée sur un corps porteur (10) et recouverte, conjointement avec le corps porteur (10), d'une couche électro-isolante (3) sur laquelle est formée une structure de piste conductrice électrique (14), les zones d'émission (21, 22, 23) présentant chacune au moins un dépôt conducteur électrique (6) relié à la structure de piste conductrice (14), et
le phare avant présentant un élément optique permettant de former un faisceau.

2. Phare avant selon la revendication 1,
**caractérisé en ce que**
la forme d'au moins une des zones d'émission (21, 22, 23) n'est pas rectangulaire dans une vue en plan du plan d'extension principal.

3. Phare avant selon la revendication 1 ou 2,
**caractérisé en ce que**
la forme d'au moins une des zones d'émission (21, 22, 23) présente un coude avec un angle aigu ou avec un angle obtus dans une vue en plan du plan d'extension principal.

4. Phare avant selon l'une des revendications précédentes,
**caractérisé en ce que**
la forme d'au moins une des zones d'émission (21, 22, 23) présente un coude avec un angle obtus dans une vue en plan du plan d'extension principal.

5. Phare avant selon l'une des revendications précédentes,
**caractérisé en ce que**
la forme d'au moins une des zones d'émission (21, 22, 23) ne présente pas d'axe de symétrie dans une vue en plan du plan d'extension principal.

6. Phare avant selon l'une des revendications précédentes,
**caractérisé en ce que**
les zones d'émission adjacentes (21, 22, 23) sont distantes entre elles de 100 µm ou moins.

7. Phare avant selon l'une des revendications précédentes,
**caractérisé en ce que**
outre la puce de diode luminescente (1), un composant électronique (100, 200), présentant au moins un dépôt conducteur électrique (106, 206) raccordé en tant que conducteur d'électricité par l'intermédiaire de la structure de piste conductrice (14) à au moins un dépôt conducteur (6) des zones d'émission (21, 22, 23), est disposé sur le corps porteur (10).

8. Phare avant selon la revendication 7,
**caractérisé en ce que**
le composant électronique (100, 200) est un composant passif (100) et/ou un circuit intégré (200).

9. Phare avant selon l'une des revendications 7 ou 8,
**caractérisé en ce que**
le composant électronique (100, 200) convient pour un montage en surface (CMS).

10. Phare avant selon l'une des revendications 1 à 9,
**caractérisé en ce que**
le dépôt conducteur (6) d'au moins une zone d'émission (21, 22, 23) est raccordé en tant que conducteur d'électricité à une zone de raccordement (8) du corps porteur (10) par l'intermédiaire de la structure de la piste conductrice (14).

11. Phare avant selon l'une des revendications 1 à 10,
**caractérisé en ce que**
la couche isolante (3) contient un matériau convertisseur de la luminescence.

12. Phare avant selon l'une des revendications 1 à 11,
**caractérisé en ce que**
la puce de diode luminescente (1) est montée sur un support de puce (20), le support de puce (20) étant appliqué sur le corps porteur (10).
